# EUROPÄISCHE PATENTSCHRIFT

(11) **EP 1 435 116 B1**
(45) Veröffentlichungstag und Bekanntmachung des Hinweises auf die Patenterteilung: **28.12.2011**
(21) Anmeldenummer: 02774613.0
(22) Anmeldetag: 13.09.2002
(51) Int. Cl.: H01L 31/0216, H01L 31/18, H01L 21/318, C09K 13/04

(54) **KOMBINIERTE ÄTZ- UND DOTIERMEDIEN**
COMBINED ETCHING AND DOPING SUBSTANCES
SUBSTANCES DE GRAVURE ET DE DOPAGE COMBINEES

(30) Priorität: 10.10.2001 DE 10150040
(43) Veröffentlichungstag der Anmeldung: 07.07.2004
(73) Patentinhaber: Merck Patent GmbH, 64293 Darmstadt (DE)
(72) Erfinder: KLEIN, Sylke, 64380 Rossdorf (DE); KÜBELBECK, Armin, 64625 Bensheim (DE); STOCKUM, Werner, 64354 Reinheim (DE); SCHMIDT, Wilfried, 74193 Schwaigern (DE); SCHUM, Berthold, 63599 Biebergmünd (DE)
(86) Internationale Anmeldenummer: PCT/EP2002/010264
(87) Internationale Veröffentlichungsnummer: WO 2003/034504

(56) Entgegenhaltungen:
- WO-A-01/83391
- DE-A- 3 725 346
- DE-A- 19 910 816
- US-A- 4 091 169

## Beschreibung

Die vorliegende Erfindung betrifft einerseits HF/Fluorid-freie Ätz- und Dotiermedien, welche sowohl zum Ätzen von anorganischen Schichten als auch zum Dotieren darunter liegender Schichten geeignet sind. Andererseits betrifft die vorliegende Erfindung auch ein Verfahren, in dem diese Medien eingesetzt werden.

Definitionsgemäß bezieht sich der Begriff "Solarzelle" im folgenden auf mono- und multi-kristalline Silizium-Solarzellen, unabhängig von Solarzellentypen, die auf anderen Materialien basieren.

Die Wirkungsweise einer Solarzelle beruht auf dem fotoelektrischen Effekt, d.h. auf der Umwandlung von Photonenenergie in elektrische Energie.

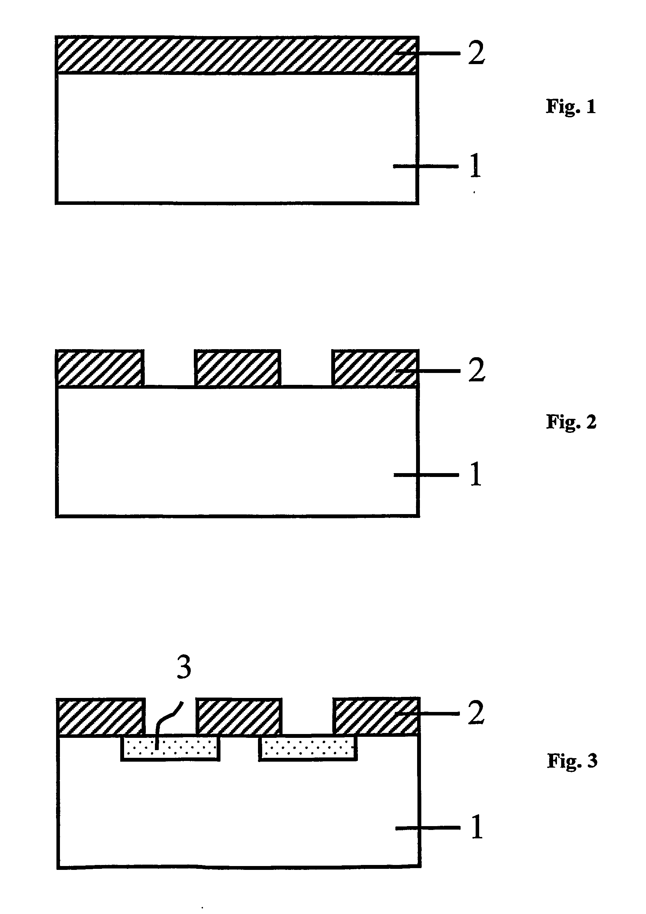

Für Siliziumsolarzellen wird dazu bereits dotiertes Silizium-Grundmaterial (meist p-dotiertes Si, Bereich 1 in Figur 1) mit den entgegengesetzten ungleichnamigen Ladungsträgern dotiert (z. B. Phosphor-Dotierung führt zur n⁺-Leitung), d.h. es wird ein p-n-Übergang erzeugt.

Bei Eintrag von Photonenenergie in die Solarzelle (Sonneneinstrahlung) werden an diesem p-n-Übergang Ladungsträger erzeugt, was zu einer Verbreiterung der Raumladungszone und zur Spannungserhöhung führt. Die Spannung wird durch Kontaktierung der Solarzelle abgegriffen und der Solarstrom zum Verbraucher abgeleitet.

Die typische Prozessfolge zur Herstellung von Solarzellen besteht vereinfacht dargestellt in:
1. Texturierung der Vorderseite der p-dotierten Si-Scheiben
2. n⁺-Dotierung (meist mit Phosphor)
3. Ätzung des PSG (Phosphorsilikatglas)
4. Passivierungs-/Antireflexbeschichtung mit Siliziumoxid- oder Siliziumnitridschichten
5. Metallisierung von Vorder- und Rückseite

Zur weiteren Betrachtung der Erfindung ist eine ausführlichere Darstellung des Schrittes 4 notwendig.

Bei einigen - historisch gesehen - älteren Produktionsverfahren wird die Passivierungsschicht über die Bildung einer thermisch erzeugten SiO₂-Schicht realisiert [A. Goetzberger, B. Voß, J. Knobloch, Sonnenenergie: Photovoltaik, S.109]. Die Funktionsweise besteht darin, dass die ungesättigten Bindungen auf der Si-Oberfläche zum größten Teil abgesättigt und dort unwirksam gemacht werden. Damit werden die Störstellendichte und Rekombinationsrate gesenkt. Durch die Einstellung der SiO₂-Schichtdicke auf ca. 100 nm (= λ/4-Regel) wird zusätzlich eine reflexionsmindernde Oberfläche erzeugt.

Aus der Literatur ist des weiteren die Beschichtung mit TiO₂-Schichten bekannt, die zwar nur einen geringen Passivierungs-Effekt zeigen, aber aufgrund des höheren Brechungsindexes deutlich zur Reflexionsminderung einer Solarzelle beitragen können [A. Goetzberger, B. Voß, J. Knobloch, Sonnenenergie: Photovoltaik, S.134].

Für die Herstellung hocheffizienter Solarzellen hat sich in der Praxis insbesondere der Einsatz von Siliziumnitrid-Schichten als Passivierungsschicht als besonders vorteilhaft erwiesen. Bekannt sind die hervorragenden Passivierungseigenschaften aus der Halbleitertechnologie, z.B. als Barriere-, Passivierungsschichten in integrierten Schaltkreisen, FET, Kondensatoren usw.

Für die Anwendung in der Solarzellenherstellung, insbesondere zur Volumenpassivierung von multikristallinem Silizium, wird Siliziumnitrid mit einem hohen Wasserstoffgehalt von 2,8x10²² cm⁻³ auf die Rückseite der Zelle aufgebracht. Bei 820 °C diffundiert der Wasserstoff ins Volumen und erhöht damit die Minoritätslebensdauer. Zur Emitterpassivierung wird Siliziumnitrid bei 625 °C in Formiergasatmosphäre getempert und führt zu einer Verbesserung der spektralen Empfindlichkeit im UV-Bereich.

Neben seinem guten Passivierungsverhalten weist Siliziumnitrid hervorragende Antireflexeigenschaften auf. Der Brechungsindex der im Plasma erzeugten Siliziumnitridschichten (PECVD) umfasst gegenüber Siliziumoxid mit n=1,4-1,5 einen weiten Bereich von n=1,6-2,7. Zudem ist die Lichtabsorption von Siliziumnitrid im sichtbaren Bereich sehr gering. [R. Hezel, Gmelin Handbook, Sci. Suppl. Vol. B 5c, S. 321]

Diese Schichten werden üblicherweise über plasma-enhanced oder low pressure CVD-Verfahren (PECVD bzw. LPCVD) aus z.B. Silan und Ammoniak mit einer Schichtdicke von ca. 70 nm erzeugt. Im gewählten Schichtdickenbereich werden neben den ausgezeichneten geringen Oberflächenrekombinationsgeschwindigkeiten [A. Goetzberger, B. Voß, J. Knobloch, Sonnenenergie:Photovoltaik, S.110; A. Ehrhardt, W. Wettling, A. Bett, J. Appl. Phys. A53, 1991, S.123] auch reflexmindernde Schichten im λ/4 Bereich erzeugt. In [US Patent 4,751,191] ist dieses Verfahren näher beschrieben.

Nach dem Stand der heutigen Technik stellt die Beschichtung einer mono- oder multi-kristallinen Solarzelle mit Siliziumnitrid das beste Verfahren zur Oberflächenpassivierung und Reflexionsminderung dar. Es wird in neueren Produktionslinien mittlerweile in der Massenfertigung eingesetzt.

Vorteilhaft für die Wirkungsgradsteigerung hat sich in Laborversuchen erwiesen, die Gebiete unter den Kontakten der Emitterseite höher als das umgebene n⁺-Gebiet zu dotieren d.h. mit Phosphor eine n⁺⁺- Diffusion vorzunehmen. Diese Strukturen werden als selektiver oder Zwei-stufen-Emitter bezeichnet [A. Goetzberger, B. Voß, J. Knobloch, Sonnenenergie:Photovoltaik, S.115, S. 141]. Die Dotierung im n⁺-Gebiet liegt dabei in einer Größenordnung von 10¹⁸ cm⁻³ und im n⁺⁺-Gebiet im Bereich von ca. 10²⁰ cm⁻³. Mit derartigen hocheffizienten Solarzellen werden im Labormaßstab Wirkungsgrade bis zu 24% erzielt.

Um diese, für den selektiven Emitter unterschiedlich stark dotierten Bereiche zu erhalten, sind in der Literatur mehrere Verfahren beschrieben, die alle auf einem Strukturierungs-Schritt basieren. Hierbei werden, zumeist durch Anwendung von fotolithografischen Methoden, in SiO₂-Schichten (Schicht 2 in Figur 1)- die eine Dotierung des darunter liegenden Siliziums in der Dampfphase verhindern - gezielt Öffnungen (in die Schicht 2, Figur 2) gebracht, die eine lokale Dotierung (n⁺⁺) ermöglichen. Diese Dotierung wird zumeist in der Gasphase mit POCl₃ oder PH₃ durchgeführt (Schicht 3 in Figur 3). Die Dotierfenster werden in das SiO₂ mit Flusssäure bzw. gepufferter Flusssäure geätzt (Figur 2).

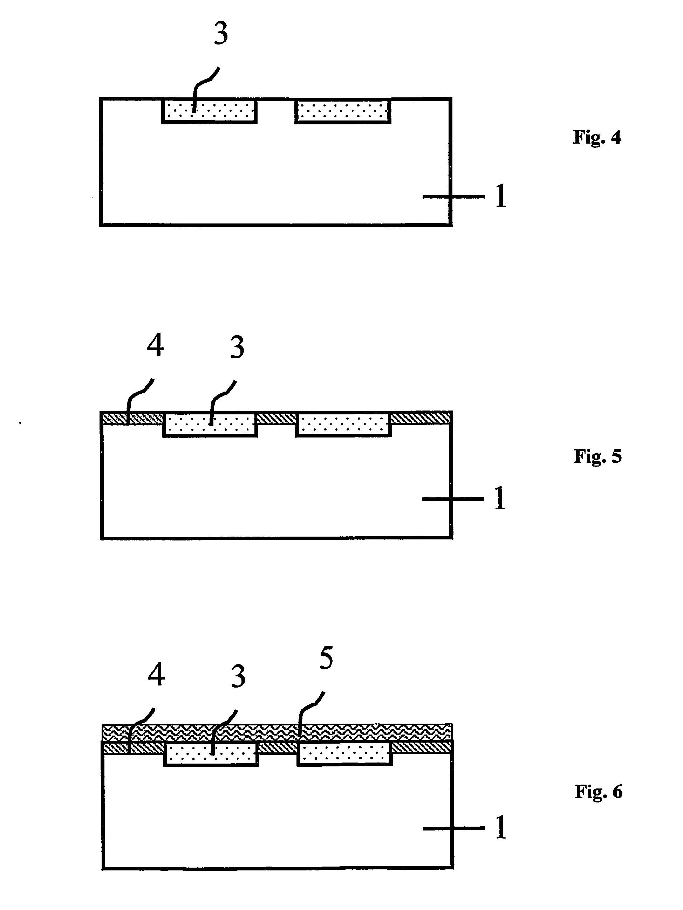

Nach der n⁺⁺-Dotierung (Schicht 3 in Figur 3) wird die SiO₂-Maske wieder vollständig entfernt (Figur 4) und die n⁺-Dotierung (Schicht 4 in Figur 5) vorgenommen. Schließlich erfolgt die Abscheidung der Antireflexschicht (Schicht 5 in Figur 6).

Aufgrund der sehr aufwendigen und teuren Prozessführung sind diese Verfahren nicht über das Laborstadium hinaus realisiert worden.

Ein anderes Verfahren beruht auf dem Abätzen der n⁺⁺-Gebiete mit einer Ätzmischung aus Flusssäure und Salpetersäure, bei gleichzeitiger Maskierung der späteren Kontaktbereiche. Auch dieses Verfahren hat sich in der Praxis wegen seiner aufwendigen Verfahrensweise nicht durchsetzen können.

All diesen Verfahren ist gemein, dass mit Flusssäure bzw. Salzen der Flusssäure die Passivierungsschicht lokal geöffnet werden muss. Zudem muss nach einem Spül- und Trocknungsschritt eine Dotierung in der Gasphase erfolgen.

Diesen Verfahren deutlich überlegen erscheint das lokale Öffnen der SiO₂ - bzw. Siliziumnitrid-Schicht mit Hilfe einer Ätzpaste, wie in DE 10101926 bzw. WO01/83 339 beschrieben, und das anschließende Dotieren in der Gasphase mit z.B. POCl₃.

Aus der Literatur ist bekannt, dass Siliziumnitrid durch heiße ortho-Phosphorsäure selektiv gegenüber SiO₂ geätzt werden kann [A.F. Bogenschütz, "Ätzpraxis für Halbleiter", Carl Hanser Verlag München, 1967]. Dies ist ein in der Mikroelektronik weit verbreitetes Verfahren. Die Phosphorsäure wird dabei üblicherweise bei Temperaturen von ca. 165°C eingesetzt und die Wafer in das Säurebad eingetaucht. Die Ätzraten liegen in diesem Temperaturbereich bei ca. 3 nm/min.

Zum Ätzen von Siliziumnitrid-Schichten auf Solarzellen ist dieses Verfahren wenig geeignet. Die Ätzraten sind für eine Massenfertigung zu gering und des weiteren besteht das Problem, dass zur Strukturierung immer noch aufwendige fotolithographische Schritte notwendig sind.

Aufgabe der vorliegenden Erfindung ist es daher, ein geeignetes Ätzmedium zur Verfügung zu stellen, mit dessen Hilfe mit hohen Ätzraten selektiv anorganische Oberflächen, insbesondere Siliziumnitridschichten von Solarzellen, geätzt werden können. Aufgabe der vorliegenden Erfindung ist es auch, ein Verfahren zum selektiven Ätzen von anorganischen Oberflächen zur Herstellung von selektiven Emitterstrukturen in Solarzellen zur Verfügung zu stellen, welches neben dem Ätzen auch eine gezielte Phosphordotierung zur Erzeugung von n⁺⁺-Gebieten er möglicht.

Die Lösung der Aufgabe erfolgt durch ein Verfahren zum Ätzen von Passivierungs- und Antireflex-Schichten aus Siliziumnitrid auf Solarzellen, in dem ein Phosphorsäure bzw. deren Salze enthaltendes Ätzmedium in einem Verfahrensschritt ganzflächig oder selektiv auf die zu ätzenden Oberflächenbereiche aufgebracht wird, insbesondere durch ein Verfahren, in dem das mit Ätzmedium versehene Silizium-Substrat ganzflächig oder lokal auf Temperaturen im Bereich von 250 bis 350 °C für 30 bis 120 Sekunden erhitzt wird und gegebenenfalls anschließend zur zusätzlichen n⁺⁺-Dotierung für 20 bis 40 Minuten auf Temperaturen > 800 °C, insbesondere auf Temperaturen im Bereich von 800 bis 1050°C, erhitzt wird.

Gegenstand der vorliegenden Erfindung ist somit ein Verfahren gemäß der nachfolgenden Ansprüche 1 und 2 sowie seiner besonderen Ausgestaltung gemäß der Ansprüche 3 bis 6. Gegenstand der Erfindung ist ebenfalls die Verwendung eines Ätzmediums gemäß der Ansprüche 7-11.

Die Lösung der erfindungsgemäßen Aufgabe erfolgt insbesondere mittels eines Ätzmediums, worin die verschiedenen Formen der Phosphorsäure oder geeignete Phosphorsäuresalze oder -verbindungen, welche beim Erhitzen zu der entsprechenden Phosphorsäure zersetzt werden, als Ätz- und gegebenenfalls als Dotierkomponente dienen.

Durch Versuche wurde gefunden, dass ortho-Phosphorsäure, metaPhosphorsäure, pyro-Phosphorsäure, bzw. deren Salze und hier insbesondere die Ammonium-Salze ((NH₄)₂HPO₄, NH₄H₂PO₄, (NH₄)₃PO₄) sowie andere Verbindungen, die bei ihrer thermischen Zersetzung eine dieser Verbindungen bildet, bei Temperaturen oberhalb 250°C in der Lage sind, Siliziumnitrid-Schichten von 70 nm Schichtdicke innerhalb weniger Sekunden bis Minuten vollständig wegzuätzen. Bei 300°C beträgt die Ätzzeit ca. 60 Sekunden.

Durch selektives Auftragen, z. B. im Siebdruck, durch das Inkjet-Verfahren oder andere Methoden, und ganzflächiges Erhitzen des beschichteten Silizium-Substrates kann zudem eine lokale Ätzung erfolgen. Das gleiche kann durch ein vollständiges Beschichten, beispielsweise durch Spin-Coating, Spray-Coating oder andere Coating-Verfahren, und lokale Erhitzung , z.B. mit einem IR-Laser, erzielt werden.

Ein Vorteil dieses Ätzverfahrens ist, dass ohne den Einsatz giftiger und teuer zu entsorgender Flusssäure bzw. Flusssäure-Salze das Siliziumnitrid geätzt werden kann. Zudem kann der Beginn und das Ende der Ätzung durch den Zeitpunkt und die Dauer der thermischen Anregung einfach gesteuert werden. Ein besonderer Vorteil ist, dass mit einer selektiv aufgedruckten Phosphorsäure (ortho-, meta- oder pyro-), bzw. einem ihrer Salze oder Verbindungen dieselbige z.B. durch thermische Anregung freigesetzt, in einem zweiten, sich unmittelbar anschließenden Prozessschritt, eine n⁺⁺-Dotierung erzeugt werden kann, wie sie im Falle des selektiven Emitters notwendig ist. Dieses Dotierungsverfahren ist dem Fachmann bekannt und kann z.B. wie in [A. Goetzberger, B. Voß, J. Knobloch, Sonnenenergie:Photovoltaik, S.115, S. 141] beschrieben durchgeführt werden.

Gegenstand der Erfindung ist es somit, selektive Emitterstrukturen durch den Einsatz von kombinierten HF/Fluorid-freien, druckfähigen Ätz- und Dotiermedien herzustellen.

Als Ätzmedien werden HF/Fluorid-freie, leicht handhabbare Mineralsäuren oder deren Salze und/oder Mischungen aus diesen verwendet, die in pastöser Form vorliegen.

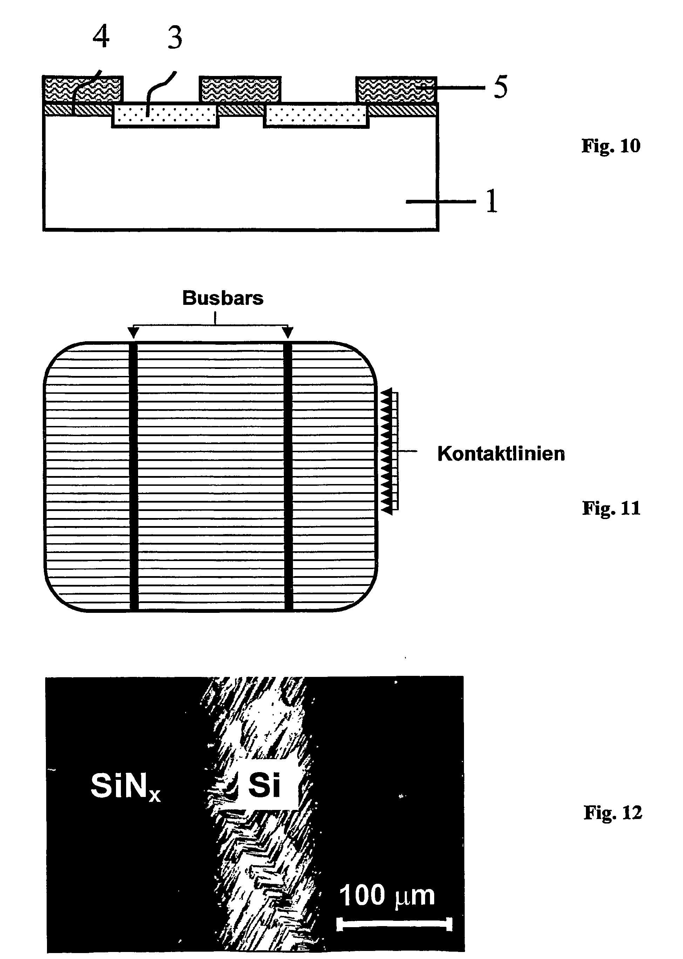

Günstiger als die ganzflächige Beschichtung ist jedoch das selektive Beschichten der Silizium-Substrate mit einer pastösen, phosphorsäurehaltigen Mischung (mögliches Layout siehe Figur 11). Dieses kann durch dem Fachmann bekannte Druckverfahren wie z.B. Sieb-, Schablonen-, Stempel-, Tampondruck erfolgen. Nach dem Auftrag erfolgt in einem nachfolgenden Schritt das Erwärmen der Substrate zur Einleitung der Siliziumnitrid-Ätzung. Dies kann auf einer Hotplate (Heizplatte) oder durch IR-Strahlung oder nach einem anderen dem Fachmann bekannten Verfahren zum Erhitzen von Substraten geschehen. Beispiele hierfür sind das Erhitzen durch Mikrowelle oder das Erhitzen im Konvektionsofen. Zur Ätzung ist ein Temperaturbereich von 250 bis 350°C vorteilhaft. Die Ätzdauer für eine 70 nm dicke PECVD Siliziumnitrid-Schicht beträgt bei 300°C ca. 60 Sekunden. Dem Ätzschritt unmittelbar nachfolgen kann in einem weiteren Schritt das Erhitzen des Substrates auf Temperaturen >800°C, wie dieses zur thermischen n⁺⁺-Dotierung mit Phosphor notwendig ist. Über die Dauer und Temperatur kann das Diffusionsprofil des Phosphors in das Silizium in der dem Fachmann bekannten Art und Weise gesteuert werden.

Vorteilhafter Weise kann hier das Ätzen und Dotieren durch eine geschickte Prozessführung in einem Temperaturschritt erfolgen.

Dieses selektive Auftragen der Ätz- und Dotiermedien ist nicht nur günstiger bzgl. des Materialverbrauches, sondern auch im Durchsatz erheblich schneller als das serielle Beschreiben einer Fläche mit einem Laser.

Im Gegensatz zu den oben genannten Druckverfahren ist der Auftrag mittels Tintenstrahldruck und Dispensertechnik - beides kontaktlose Verfahren - als eine weitere Variante zu nennen. Es kann auf diese Weise ein erwärmtes Substrat direkt bedruckt und geätzt werden. Auch hier ist durch eine geschickte Prozessführung ein simultanes Ätzen und Dotieren möglich.

Die als Ätzmedien verwendeten Pasten , können ganzflächig oder selektiv an den zu dotierenden Stellen aufgetragen werden.

Enthalten die Pasten zudem noch Dotierungselemente wie Phosphor, dann können sie nach dem eigentlichen Ätzschritt als Dotierquelle dienen.

Dazu werden die Solarzellen Temperaturen von 800-1000 °C ausgesetzt, wobei das in der Paste enthaltene Dotierungselement in die Kontaktierungsbereiche hinein diffundiert und diese dotiert. Alle anderen Pastenkomponenten sind bei diesen Temperaturen flüchtig und verbrennen ohne Rückstände.

Die Paste wird in einem einzigen Verfahrensschritt auf die gewünschten Bereiche der zu ätzenden Oberfläche aufgebracht. Eine für die Übertragung der Paste auf die Oberfläche geeignete Technik mit hohem Automatisierungsgrad ist die Drucktechnik. Speziell die Sieb-, Schablonen-, Tampon-, Stempel- Drucktechnik sind dem Fachmann bekannte Verfahren.

Sämtliche Maskierungs- und Lithografieschritte, die für eine Anwendung der nasschemischen Ätzverfahren bzw. der selektiven Dotierung in der Gasphase notwendig sind, aber auch Spülvorgänge entfallen. Auf diese Weise kann im erfindungsgemäßen Verfahren neben Materialien auch Zeit eingespart werden. Weiterhin fallen wesentlich geringere Mengen an verunreinigten Chemikalien an, wieder aufgearbeitet oder entsorgt werden müssen.

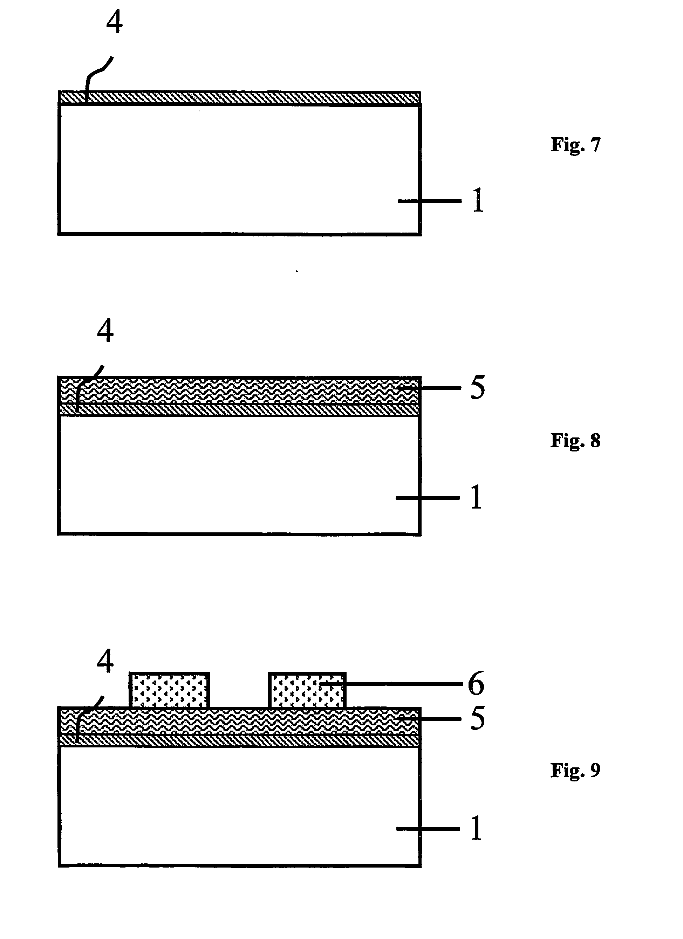

Eine mögliche Prozessfolge ist in den Figuren 7 - 10 dargestellt. Nach einer konventionellen n⁺-Dotierung (Schicht 4 in Figur 7) und Siliziumnitridabscheidung (als Antireflexschicht, Schicht 5 in Figur 8) wird der Wafer mit der erfindungsgemäß beschriebenen kombinierten Ätz- und Dotierpaste (Schicht 6 in Figur 9) selektiv bedruckt. Diese ätzt zum einen selektiv die Siliziumnitridschicht und kann unter Energiezufuhr in den Siliziumwafer eingetrieben werden. Dabei bildet sich die n⁺⁺-Schicht unter den vormals bedruckten Strukturen (Schicht 3 in Figur 10).

Vorteilhaft ist neben dem in einem Prozess ablaufenden Ätz- und Dotiervorgang, dass die im nächsten Schritt zu kontaktierenden Bereiche bereits frei liegen. So kann sofort eine elektrochemische Kontaktierung erfolgen oder Metallpasten verwendet werden, die nicht unter hohem Energieaufwand eingefeuert werden müssen.

Die erfindungsgemäßen Ätzpasten setzen sich zusammen aus:
a. Ätz- und ggf. Dotierkomponente
b. Lösungsmittel
c. Verdickungsmittel
d. gegebenenfalls Additive wie Entschäumer, Thixotropiermittel, Verlaufsmittel, Entlüfter, Haftvermittler

Die Ätzwirkung der vorgeschlagenen Ätzpasten beruht auf einer sauren Komponente, die durch Temperaturanregung wirksam ist. Diese Komponente stammt aus der Gruppe der Phosphorsäure (ortho, meta, pyro) und deren Salze, vorzugsweise Ammonium-Salze ((NH₄)₂HPO₄ NH₄H₂PO₄, (NH₄)₃PO₄).

Die Ätzkomponente liegt in einem Konzentrationsbereich von 1 - 80 Gew.- % bezogen auf die Gesamtmasse der Ätzpaste vor. Durch die Konzentration der Ätzkomponente kann die Ätz- und Abtragsrate an Siliziumnitrid deutlich beeinflusst werden.

In weiteren Versuchen zeigte es sich, dass durch den Zusatz einer stark oxidierenden Komponente, wie z.B. Salpetersäure oder Nitrate, die Ätzrate der Phosphorsäure weiter erhöht werden kann.

Der Anteil des Lösungsmittels kann im Bereich von 20-80 Gew.- % bezogen auf die Gesamtmasse der Ätzpaste liegen. Geeignete Lösungsmittel können reine anorganische oder organische Lösungsmittel bzw. Mischungen derselben sein wie Wasser, einfache und/oder mehrwertige Alkohole, Ether, insbesondere Ethylenglycolmonobutylether, Triethylenglykolmonomethylether, [2,2-Butoxy-(Ethoxy)]-Ethylacetat sein.

Der Anteil des Verdickungsmittel, der zur gezielten Einstellung des Viskositätsbereiches und grundsätzlich zum Erzielen der Druckfähigkeit des Ätzmittels, d.h. zur Bildung einer druckfähigen Paste erforderlich ist, liegt im Bereich von 1 - 20 Gew.- % bezogen auf die Gesamtmasse der Ätzpaste.

Die Strukturviskosität der beschriebenen Ätzpasten wird durch netzwerkbildende, in der flüssigen Phase quellend wirkende Verdickungsmittel erzielt und lässt sich je nach gewünschtem Einsatzgebiet variieren. Als Verdickungsmittel können organische oder anorganische Produkte oder Mischungen derselben zum Einsatz kommen:
- Cellulose/Cellulosederivate wie Ethyl-, Hydroxylpropyl-, Hydroxylethyl-, Natrium-Carboxymethylcellulose
- Stärke/Stärkderivate wie Natriumcarboxymethylstärke (vivastar®), Anionisches Heteropoly-Saccharide)
- Acrylate (Borchigel®)
- Polymere wie Polyvinylalkohole (Mowiol®), Polyvinylpyrolidone (PVP)
- Hochdisperse Kieselsäuren wie Aerosil®

Anorganische Verdickungsmittel, wie z.B. hochdisperse Kieselsäure, verbleiben im Gegensatz zu den organischen Verdickungsmitteln auch beim anschließenden Dotierschritt bei >800°C auf dem Substrat und können so zur Einstellung der Dotierglas-Eigenschaften verwendet werden. Beide Typen von Verdickungsmitteln, organische und anorganische, können auch beliebig kombiniert werden.

Additive mit für den gewünschten Zweck vorteilhaften Eigenschaften sind Entschäumer, Thixotropiermittel, Verlaufsmittel / Antiverlaufsmittel, Entlüfter und Haftvermittler. Aus den im Handel erhältlichen Additiven ist es dem Fachmann ohne weiteres möglich, geeignete Additive auszuwählen, die den gültigen Anforderungen für die Herstellung von Solarzellen entsprechen. Durch die gezielte Zugabe dieser Additive kann die Druckfähigkeit der Ätzpaste positiv beeinflusst werden.

Zur Erzielung hoher Wirkungsgrade in einer Solarzelle ist es wichtig, dass alle Ausgangsstoffe zur Herstellung der Ätzpaste über eine ausreichende Reinheit verfügen. Insbesondere die leicht diffundierenden Elemente wie z.B. Kupfer, Eisen, Natrium, die im Silizium die Trägerlebensdauer erheblich verkürzen, sollten in Konzentrationen < 200 ppb vorhanden sein.

Erfindungsgemäß können diese neuen Ätz- und Dotierpasten in der Solarzellenindustrie zur Herstellung von Photovoltaik eingesetzt werden - Bauelementen wie Solarzellen oder Photodioden. Insbesondere können die erfindungsgemäßen Pasten in einem zweistufigen Verfahren zur Herstellung von Emitterstrukturen eingesetzt werden.

In Fig. 11 ist ein Layout einer auf einer Siliziumnitridoberfläche geätzten Struktur gezeigt, die mit einer Ätzpaste nach Beispiel 2 hergestellt worden ist (mikroskopische Aufnahme, Figur 12).

Zum besseren Verständnis und zur Verdeutlichung werden im folgenden Beispiele gegeben, die im Rahmen des Schutzbereiches der vorliegenden Erfindung liegen, jedoch nicht geeignet sind, die Erfindung auf diese Beispiele zu beschränken.

### Beispiel 1:

### Herstellung und Zusammensetzung der Paste

In 100 g ortho-Phosphorsäure 85% (Merck Art. 1.00573) wird unter Rühren 6 g Aerosil 200 (Degussa-Huels AG) eingerührt. Die entstehende Paste wird noch weitere 20 min mit einem Flügelrührer gerührt.

### Beispiel 2:

### Herstellung und Zusammensetzung der Paste

In ein Gemisch, bestehend aus 48,5 Gew.- % H₃PO₄ (85%ig) und 48,5 Gew.- % 1-Methyl-2-pyrrolidon, wird unter Rühren 3 Gew.- % PVP K90 eingerührt. Die entstehende Paste wird noch weitere 20 min mit einem Flügelrührer gerührt.

Eine in der beschriebenen Weise hergestellte Ätzpaste wird mit einem Polyestersieb Typ 120 T auf einer handelsüblichen Siebdruckmaschine verdruckt. Auf dem Sieb wird das in Fig. 11 dargestellte Layout abgebildet und auf das Substrat übertragen. Als Substrat wird eine multi-kristalline Solarzelle von 100x100 mm Größe mit einer ganzflächigen Siliziumnitrid-Passivierungsschicht eingesetzt. Unmittelbar nach dem Bedrucken wird das Substrat 100 Sekunden bei 300°C auf einer Hotplate erhitzt. Das vollständige Durchätzen der Siliziumnitrid-Schicht ist visuell bereits nach ca. 60 Sekunden zu erkennen (Fig. 12). Danach wird das Substrat 30 min bei 850°C in einen Diffusionsofen mit atmosphärischer Luft eingebracht.

Nach dem Entfernen der Phosphorglasschicht kann die lokale, hohe Dotierung mit Phosphor im Bereich von ca. 10²⁰ cm⁻³ nachgewiesen werden.

## Patentansprüche

1. Verfahren zum Ätzen von Passivierungs- und Antirefilex-Schichten aus Siliziumnitrid auf einer Silizium-Solarzelle, **dadurch gekennzeichnet, dass** ein Phosphorsäure bzw. deren Salze enthaltendes druckfähiges, pastenförmiges Ätzmedium, in einem Verfahrensschritt ganzflächig oder selektiv auf die zu ätzenden Oberflächenbereiche aufgebracht wird und auf eine Temperatur im Bereich von 250 bis 350 °C für 30 bis 120 Sekunden erhitzt wird.

2. Verfahren gemäß Anspruch 1 **dadurch gekennzeichnet, dass** das mit Ätzmedium versehene Silizium-Substrat ganzflächig oder lokal auf Temperaturen im Bereich von 250 bis 350 °C für 30 bis 120 Sekunden erhitzt wird und gegebenenfalls anschließend zur zusätzlichen n⁺⁺-Dotierung für 20 bis 40 Minuten auf Temperaturen > 800 °C, insbesondere auf Temperaturen im Bereich von 800 bis 1054°C, erhitzt wird.

3. Verfahren gemäß der Ansprüche 1 - 2, **dadurch gekennzeichnet, dass** das Ätzmedium je nach Konsistenz durch Drucken im Sieb-, Schablonen-, Stempel-, Tampon- oder Tintenstrahldruck und Dispensertechnik aufgebracht wird.

4. Verfahren gemäß der Ansprüche 1 - 3, **dadurch gekennzeichnet, dass** das Erhitzen auf einer Heizplatte, im Konvektionsofen, durch IR-Strahlung, UV-Strahlung, oder Mikrowelle erfolgt.

5. Verfahren gemäß der Ansprüche 1-3. **dadurch gekennzeichnet, dass** zum lokalen Erhitzen ein Laser, insbesondere für das Erhitzen auf Temperaturen > 800 °C, ein IR-Laser verwendet wird.

6. Verfahren gemäß der Ansprüche 1 - 5 zur Herstellung von Solarzellen mit Zwei-Stufen-Emittern.

7. Verwendung eines druchfähigen, pastenformigen Ätzmediums, enthaltend als aktive Komponente ortho-, meta-, pyro-Phosphorsaure, und/oder meta-Phosphorpentoxid oder deren Gemische, welche sowohl als Ätz- als auch als Dotierkomponente wirkt, zum Ätzen von anorganischen Passivierungs- und Antireflex-Schichten auf Solarzellen und zum n⁺⁺-Dotieren des Siliziums in aufeinander folgenden Schritten.

8. Verwendung eines Ätzmediums gemäß Anspruch 7, enthaltend ein oder verschiedene Ammoniumsalz(e) der Phosphorsaure und/oder mono- oder di-Ester einer Phosphorsaure, die durch thermischen Energieeintrag die ätzende Phosphorsäure freisetzen.

9. Verwendung eines Ätzmediums gemäß der Ansprüche 7 - 8 in Pastenform, enthaltend außer einer Ätz- und Dotierkomponente, Lösungsmittel, Verdickungsmittel und gegebenenfalls Additive wie Entschäumer, Thixotropiermittel. Verlaufsmittel, Entlüfter und Haftvermittler.

10. Verwendung eines Atzmediums gemäß der Ansprüche 7 - 9 zur Herstellung einer Solarzellen mit Zwei-Stufen-Emittem.

11. Verwendung eines Ätzmediums gemäß der Ansprüche 7 - 9 in einem Verfahren gemäß der Ansprüche 1 - 6.

## Claims

1. Process for the etching of silicon nitride passivation and antireflection layers on a silicon solar cell, **characterised in that** a printable, paste-form etching medium comprising phosphoric acid or salts thereof is applied, in one process step, over the entire surface or selectively to the surface regions to be etched and heated to a temperature in the range from 250 to 350°C for 30 to 120 seconds.

2. Process according to Claim 1, **characterised in that** the silicon substrate provided with etching medium is heated over the entire surface or locally to temperatures in the range from 250 to 350°C for 30 to 120 seconds and, if desired, for additional n⁺⁺ doping, subsequently heated to temperatures of > 800°C, in particular to temperatures in the range from 800 to 1050°C, for 20 to 40 minutes.

3. Process according to Claims 1 - 2, **characterised in that** the etching medium is applied, depending on consistency, by screen printing, stencil printing, stamp printing, pad printing or ink-jet printing and the dispenser method.

4. Process according to Claims 1 - 3, **characterised in that** the heating is carried out on a hotplate, in a convection oven, by IR radiation, UV radiation or microwaves.

5. Process according to Claims 1 - 3, **characterised in that** the local heating is carried out using a laser, in particular an IR laser for heating to temperatures of > 800°C.

6. Process according to Claims 1 - 5 for the production of solar cells with two-stage emitters.

7. Use of a printable, paste-form etching medium comprising, as active component, ortho-, meta- or pyrophosphoric acid, and/or metaphosphorus pentoxide or mixtures thereof, which acts both as etching component and as doping component, for the etching of inorganic passivation and antireflection layers on solar cells and for the n⁺⁺ doping of silicon in successive steps.

8. Use of an etching medium according to Claim 7, comprising one or more ammonium salt(s) of phosphoric acid and/or mono- or diesters of a phosphoric acid, which liberate the etching phosphoric acid through thermal input of energy.

9. Use of an etching medium according to Claims 7 - 8 in paste form, comprising, in addition to an etching and doping component, solvents, thickeners and optionally additives, such as antifoams, thixotropic agents, flow-control agents, deaerators and adhesion promoters.

10. Use of an etching medium according to Claims 7 - 9 for the production of a solar cell with two-stage emitters.

11. Use of an etching medium according to Claims 7 - 9 in a process according to Claims 1 - 6.

## Revendications

1. Procédé pour la gravure de couches de passivation et antireflet en nitrure de silicium sur une cellule solaire en silicium, **caractérisé en ce qu'**un milieu de gravure sous forme de pâte imprimable comprenant de l'acide phosphorique ou ses sels est appliqué, dans une étape de procédé, sur la totalité de la surface ou de façon sélective sur les régions de surface destinées à être gravées et est chauffé jusqu'à une température dans la plage de 250 à 350°C pendant 30 à 120 secondes.

2. Procédé selon la revendication 1, **caractérisé en ce que** le substrat en silicium muni du milieu de gravure est chauffé sur la totalité de la surface ou localement jusqu'à des températures dans la plage de 250 à 350°C pendant 30 à 120 secondes et, si souhaité, pendant un dopage n⁺⁺ additionnel, est chauffé ensuite jusqu'à des températures > 800°C, en particulier jusqu'à des températures dans la plage de 800 à 1050°C, pendant 20 à 40 minutes.

3. Procédé selon les revendications 1 - 2, **caractérisé en ce que** le milieu de gravure est appliqué, en fonction de sa consistance, par impression par sérigraphie, par impression stencil, par impression par matriçage, par impression par tampon ou par impression par jet d'encre et par le procédé de distribution.

4. Procédé selon les revendications 1 - 3, **caractérisé en ce que** le chauffage est mis en oeuvre sur une plaque chaude, dans un four à convection, par rayonnement IR, par rayonnement UV ou par micro-ondes.

5. Procédé selon les revendications 1 - 3, **caractérisé en ce que** le chauffage est mis en oeuvre en utilisant un laser, en particulier un laser IR pour un chauffage jusqu'à des températures > 800°C.

6. Procédé selon les revendications 1 - 5 pour la fabrication de cellules solaires avec des émetteurs à deux étages.

7. Utilisation d'un milieu de gravure sous forme de pâte imprimable, comprenant, en tant que composant actif, de l'acide ortho-, méta- ou pyrophosphorique, et/ou du pentoxyde méta-phosphoreux ou des mélanges afférents, lequel agit à la fois en tant que composant de gravure et en tant que composant de dopage, pour la gravure de couches de passivation et antireflet inorganiques sur des cellules solaires et pour le dopage n⁺⁺ de silicium selon des étapes successives.

8. Utilisation d'un milieu de gravure selon la revendication 7, comprenant un ou plusieurs sel(s) d'ammonium d'acide phosphorique et/ou des mono- ou diesters d'un acide phosphorique, lesquels libèrent l'acide phosphorique de gravure par l'intermédiaire d'une entrée thermique d'énergie.

9. Utilisation d'un milieu de gravure selon les revendications 7 - 8 sous forme de pâte, comprenant, en plus d'un composant de gravure et de dopage, des solvants, des épaississants et en option, des additifs, tels que des antiémulsifiants, des agents thixotropiques, des agents de contrôle de flux, des désaérateurs et des agents favorisant l'adhérence.

10. Utilisation d'un milieu de gravure selon les revendications 7 - 9 pour la fabrication d'une cellule solaire avec des émetteurs à deux étages.

11. Utilisation d'un milieu de gravure selon les revendications 7 - 9 dans un procédé selon les revendications 1 - 6.
